# EUROPEAN PATENT SPECIFICATION

(11) **EP 3 225 600 B1**
(45) Date of publication and mention of the grant of the patent: **04.11.2020**
(21) Application number: 15864239.7
(22) Date of filing: 16.11.2015
(51) Int. Cl.: C03C 17/25, C03C 17/34, H01L 31/0392, C03C 17/00

(54) **GLASS PLATE WITH LOW-REFLECTION COATING**
GLASPLATTE MIT BESCHICHTUNGEN MIT GERINGER REFLEXION
PLAQUE DE VERRE AYANT UN REVÊTEMENT FAIBLEMENT RÉFLÉCHISSANT

(30) Priority: 28.11.2014 JP 2014241445
(43) Date of publication of application: 04.10.2017
(73) Proprietor: Nippon Sheet Glass Company, Limited, Tokyo 108-6321 (JP)
(72) Inventor: MIYAMOTO, Yoko, Tokyo 108-6321 (JP); KOYO, Mizuho, Tokyo 108-6321 (JP); KAWAZU, Mitsuhiro, Tokyo 108-6321 (JP)
(74) Representative: Cabinet Beau de Loménie
(86) International application number: PCT/JP2015/005708
(87) International publication number: WO 2016/084331

(56) References cited:
- WO-A1-2010/018852
- WO-A1-2014/112526
- JP-A- 2002 139 603
- JP-A- 2002 234 754
- JP-A- 2013 121 893
- JP-A- 2013 537 873
- KR-B1- 100 682 124
- US-A1- 2002 014 090
- US-A1- 2002 014 090
- US-A1- 2008 241 373

## Description

### TECHNICAL FIELD

The present invention relates to a low-reflection coated glass sheet.

### BACKGROUND ART

It is conventional practice to form a low-reflection coating on a glass sheet for the purpose of improving the function of the glass sheet, such as increasing the amount of light to be transmitted through the glass sheet or enabling prevention of glare. A low-reflection coated glass sheet including a glass sheet and a low-reflection coating formed on the glass sheet is used, for example, in a photoelectric conversion device such as a thin-film solar cell. In this case, placing the low-reflection coating on the sunlight-incident side of the low-reflection coated glass sheet allows more sunlight to be introduced to the photoelectric conversion layer or solar cell element of the photoelectric conversion device. This can result in an increase in the electricity generated by the photoelectric conversion device.

For example, Patent Literature 1 describes a cover glass for photoelectric conversion devices that has a reflection-reducing film. This cover glass having the reflection-reducing film is produced by applying a coating liquid containing fine silica particles and a compound as a binder source to a glass sheet having certain surface asperities by spraying, followed by drying and sintering. The average light transmittance of this cover glass in the wavelength range of 380 nm to 1100 nm can be increased by 2.37% or more, as compared to that of a glass sheet having no reflection-reducing film.

Patent Literature 2 describes a glass substrate including a glass sheet and a porous anti-reflection layer formed on the glass sheet. This glass substrate is produced by depositing a blend for priming on one surface of an ultra-transparent glass sheet by dip coating, then drying the blend on the glass sheet to obtain a substrate, then depositing another mixture on the substrate by dip coating, and finally subjecting the substrate to a predetermined heat treatment. The blend for priming is prepared by adding tetraethoxysilane (TEOS) and zirconium acetylacetonate to a predetermined solution. The other mixture is prepared by adding tetraethoxysilane (TEOS), aluminum acetylacetonate, and colloidal silica to a predetermined solution. This glass substrate has been observed to exhibit an increase of 2.2% to 2.6% in light transmittance in the wavelength range of 300 nm to 1100 nm.

Patent Literature 3 describes a coating composition prepared by using a PGME-dispersed silica sol and a binder solution. The PGME-dispersed silica sol is one prepared by adding propylene glycol monomethyl ether (PGME) to a dispersion of silica, and the binder solution is one prepared by mixing tetraethoxysilane and aluminum nitrate nonahydrate. An aqueous dispersion of colloidal silica having a dispersed particle diameter greater than an average primary particle diameter is used in the PGME-dispersed silica sol. A coating obtained by using this coating composition has a refractive index of 1.2656 to 1.2960 at a wavelength of 633 nm.

### CITATION LIST

### Patent Literature

Patent Literature 1: JP 2014-032248 A
Patent Literature 2: JP 2013-537873 A
Patent Literature 3: JP 2014-015543 A

US20110135941 discloses a substrate having an anti-reflection layer.

### SUMMARY OF INVENTION

### Technical Problem

Properties called "reflectance loss" and "transmittance gain" are important for low-reflection coated glass sheets. The term "reflectance loss" is used, in relation to average light reflectance in a predetermined wavelength range, to refer to a decrease in the average reflectance produced by formation of a low-reflection coating. Specifically, the reflectance loss is determined by subtracting an average light reflectance of a glass sheet provided with a low-reflection coating in a predetermined wavelength range from an average reflectance of the glass sheet unprovided with the low-reflection coating in the predetermined wavelength range. The term "transmittance gain" is used, in relation to average light transmittance in a predetermined wavelength range, to refer to an increase in the average transmittance produced by formation of a low-reflection coating. Specifically, the transmittance gain is determined by subtracting an average light transmittance of a glass sheet unprovided with a low-reflection coating in a predetermined wavelength range from an average light transmittance of the glass sheet provided with the low-reflection coating in the predetermined wavelength range.

A low-reflection coating of a low-reflection coated glass sheet may scrape against foreign matters such as sand dust, depending on the environment where the low-reflection coated glass sheet is used. It is desirable for the low-reflection coated glass sheet to maintain a large reflectance loss even in such a case. Patent Literature 1 to 3 give no particular discussion of how the reflectance loss is influenced by scraping of a low-reflection coating against foreign matters. The present invention aims to provide a low-reflection coated glass sheet that maintains a large reflectance loss even when scraping against foreign matters.

### Solution to Problem

The present invention provides a low-reflection coated glass sheet as from claim 1.

### Advantageous Effects of Invention

The low-reflection coated glass sheet of the present invention maintains a large reflectance loss even when scraping against foreign matters.

### BRIEF DESCRIPTION OF DRAWINGS

FIG. 1 is a field emission scanning electron microscope (FE-SEM) photograph of a low-reflection coated glass sheet according to Example 2.
FIG. 2 is a FE-SEM photograph of a low-reflection coated glass sheet according to Example 10.
FIG. 3 is a FE-SEM photograph of a low-reflection coated glass sheet according to Example 11.
FIG. 4 is a FE-SEM photograph of a low-reflection coated glass sheet according to Comparative Example 2.

### DESCRIPTION OF EMBODIMENTS

A low-reflection coated glass sheet according to the present invention includes a glass sheet and a low-reflection coating. The low-reflection coating contains 60 mass% to 100 mass% of a silica material having a continuous structure. The silica material having the continuous structure is in the form of a bulk in the low-reflection coating and serves to define the shape of the low-reflection coating. This silica material is distinguished from fine silica particles described below. When the low-reflection coating contains a particulate component, the silica material having the continuous structure serves also as a binder for binding the particulate component. When the content of the silica material having the continuous structure in the low-reflection coating is 60 mass% to 100 mass%, the low-reflection coated glass sheet maintains a large reflectance loss even when scraping against foreign matters. This is presumably because the low-reflection coating has a small surface roughness as well as increased adhesion to the glass sheet and is thus resistant to delaminating from the glass sheet. The content of the silica material having the continuous structure in the low-reflection coating is, for example, 60 mass% to 95 mass%. To enable the low-reflection coated glass sheet to maintain as large a reflectance loss as possible when scraping against foreign matters, it is desirable for the content of the silica material having the continuous structure in the low-reflection coating to be 60 mass% to 80 mass%. From another viewpoint, particularly in terms of reducing the increase in average reflectance of the low-reflection coated glass sheet caused by scraping of the low-reflection coated glass sheet against foreign matters, it is desirable for the content of the silica material having the continuous structure in the low-reflection coating to be 80 mass% to 100 mass%. The silica material having the continuous structure may or may not contain an organic group. For example, the silica material having the continuous structure may be formed of a hydrolysis-condensation product derived from a tetrafunctional silicon alkoxide and represented by SiO₂ or may be formed of a hydrolysis-condensation product derived from a trifunctional silicon alkoxide and represented by RSiO_{1.5}. R represents a non-hydrolyzable organic group. Examples of the organic group contained in the silica material having the continuous structure include methyl, ethyl, phenyl, glycidoxyalkyl, epoxy, acryl, methacryl, and amino groups.

The silica material having the continuous structure can be formed, for example, by a sol-gel process, in which a hydrolyzable silicon compound such as a silicon alkoxide undergoes hydrolysis and condensation. In this case, the silicon alkoxide used can be, for example, tetramethoxysilane, tetraethoxysilane, or tetraisopropoxysilane. Other examples of silicon alkoxides that can be used include trifunctional or difunctional silicon alkoxides such as methyltrimethoxysilane, methyltriethoxysilane, dimethyldiethoxysilane, diethyldiethoxysilane, phenyltriethoxysilane, glycidoxyalkyltrialkoxysilanes (such as 3-glycidoxypropyltrimethoxysilane), other epoxy silanes, acrylsilanes, methacrylsilanes, and aminosilanes. It is desirable for the silica material having the continuous structure to have a solid structure in which no voids can be observed with a scanning electron microscope.

When the silica material having the continuous structure contains an organic group, the low-reflection coated glass sheet is likely to have a high transmittance gain. When the content of the organic group in the low-reflection coating is 7 mass% or less, the low-reflection coated glass sheet is likely to maintain a large reflectance loss even when scraping against foreign matters. In view of these facts, the content of the organic group in the low-reflection coating is 0.3 to 7.0 mass%, and the lower limit of the content of the organic group in the low-reflection coating is more desirably 0.4 mass% or more. When the content of the organic group in the low-reflection coating is 2 mass% or less, the increase in average reflectance of the low-reflection coated glass sheet caused by scraping of the low-reflection coated glass sheet against foreign matters is likely to be reduced.

The surface morphology of the glass sheet is, but not limited to, such that the arithmetic average roughness Ra of the glass sheet is, for example, 1 nm or less and desirably 0.5 nm or less. The arithmetic average roughness Ra is defined herein according to Japanese Industrial Standards (JIS) B 0601-1994. An example of such a glass sheet is a glass sheet produced by a float process. That is, the glass sheet to be used is produced, for example, by a float process. The glass sheet produced by a float process has a bottom surface (tin side) and a top surface (non-tin side). The bottom surface is one of the principal surfaces of the glass sheet, while the top surface is the other principal surface of the glass sheet opposite to the bottom surface. The bottom surface is a surface formed by glass having contacted with molten tin in a float bath during the step of forming the glass sheet in the float process. The low-reflection coating is desirably formed on at least a portion of the bottom surface of the glass sheet. In this case, the reflectance loss that the low-reflection coated glass sheet maintains after scraping of the low-reflection coating against foreign matters can be larger than when the low-reflection coating is formed on the top surface of the glass sheet. This is presumably because the tin content of the glass sheet produced by the float process is higher in the vicinity of the bottom surface than in the vicinity of the top surface due to the contact of the bottom surface with molten tin in the float bath so that the formation of the low-reflection coating on the bottom surface allows the low-reflection coated glass sheet to have better reflection performance.

Alternatively, the glass sheet may be figured glass having a surface with asperities. The mean spacing Sm of the asperities is 0.3 mm or more and 2.5 mm or less, desirably 0.3 mm or more, more desirably 0.4 mm or more, and particularly desirably 0.45 mm or more. The mean spacing Sm is desirably 2.5 mm or less, more desirably 2.1 mm or less, even more desirably 2.0 mm or less, and particularly desirably 1.5 mm or less. The mean spacing Sm as defined herein refers to an average of lengths of peak-valley periods in a roughness profile which are determined based on points at which the roughness profile intersects the mean line. It is further desirable that the surface asperities of the figured glass sheet have a maximum height Ry of 0.5 µm to 10 µm, particularly 1 µm to 8 µm, as well as having a mean spacing Sm within the above range. The mean spacing Sm and the maximum height Ry as defined herein correspond to those as specified in JIS B 0601-1994. It is desirable that the surface asperities of the glass sheet in the form of figured glass have an arithmetic average roughness Ra of 0.3 µm to 5.0 µm, particularly 0.4 µm to 2.0 µm, more particularly 0.5 µm to 1.2 µm, as well as having a mean spacing Sm and a maximum height Ry within the above ranges. The figured glass as described above exhibits a sufficient anti-glare effect attributed to its surface asperities; however, when the roughness of the surface is significantly large, reflected color is likely to become uneven in the surface. The glass sheet is desirably as free of coloring components as possible, although the composition of the glass sheet is not particularly limited. For example, the content of iron oxide, which is a typical coloring component, in the glass sheet is desirably 0.06 mass% or less and more desirably 0.02 mass% or less when calculated as Fe₂O₃ content.

When the glass sheet is one produced by a float process, the low-reflection coated glass sheet may further include a transparent electrode film formed on the principal surface of the glass sheet opposite to the bottom surface (top surface). In this case, for example, one or more underlayers and a transparent electrode layer containing fluorine-doped tin oxide as a main component are stacked in order on the top surface of the glass sheet.

The thickness of the low-reflection coating is, for example, but not limited to, 80 nm to 800 nm, desirably 100 nm to 500 nm, and more desirably more than 100 nm and 300 nm or less.

The low-reflection coating may further contain fine silica particles having an average particle diameter of 5 nm to 300 nm. In this case, the content of the silica material having the continuous structure in the low-reflection coating is, for example, 60 mass% to 95 mass%, and the content of the fine silica particles in the low-reflection coating is, for example, 5 mass% to 40 mass%. This allows the low-reflection coated glass sheet to maintain a large reflectance loss even when scraping against foreign matters. The average particle diameter of the fine silica particles, as defined herein, refers to the average particle diameter of primary particles of the fine silica particles. The term "average particle diameter" as used herein refers to a particle diameter at 50% cumulative volume in a particle size distribution (D50) measured by laser-diffraction particle size distribution analysis.

The average particle diameter of the fine silica particles contained in the low-reflection coating may be 5 nm to 30 nm. In this case, the content of the silica material having the continuous structure in the low-reflection coating is, for example, 70 mass% to 95 mass%. The content of the fine silica particles in the low-reflection coating is, for example, 5 mass% to 30 mass%. This allows an increase in the reflectance loss that the low-reflection coated glass sheet exhibits after scraping against foreign matters. In this case, the average particle diameter of the fine silica particles is desirably 10 nm to 30 nm.

The average particle diameter of the fine silica particles contained in the low-reflection coating may be 30 nm to 150 nm. In this case, the content of the silica material having the continuous structure in the low-reflection coating is, for example, 60 mass% to 80 mass%. The content of the fine silica particles in the low-reflection coating is, for example, 20 mass% to 40 mass%. This allows an increase in the reflectance loss that the low-reflection coated glass sheet exhibits after scraping against foreign matters. In addition, the reflectance loss that the low-reflection coated glass sheet exhibits before scraping against foreign matters can also be increased. In this case, the average particle diameter of the fine silica particles is desirably 70 nm to 130 nm.

The low-reflection coating contains a compound of a metal other than silicon. "Silicon" is considered herein to be included in metals. Examples of the metal compound include compounds of metals such as aluminum, titanium, and zirconium, and typical examples include alkoxides, inorganic salts, and halides of metals such as aluminum, titanium, and zirconium. In particular, the metal compound is desirably a chloride. The metal constituting the metal compound is aluminum. The metal compound is added to a coating liquid for forming the low-reflection coating. The content of the metal compound calculated as an oxide of the metal in the low-reflection coating is, 2 mass% to 8 mass%. The low-reflection coating contains, an aluminum compound. The aluminum compound contained in the low-reflection coating is derived, for example, from an aluminum halide added to the coating liquid for forming the low-reflection coating. In this case, the aluminum halide is desirably aluminum chloride. The content of the aluminum compound calculated as Al₂O₃ in the low-reflection coating is, 2 mass% to 8 mass%. To enable the low-reflection coated glass sheet to maintain a large reflectance loss even when scraping against foreign matters, the content of the aluminum compound in the low-reflection coating is, for example, 8 mass% or less, desirably 7 mass% or less, and more desirably 6 mass% or less. In terms of enhancing the chemical resistance, such as salt spray resistance, of the low-reflection coating, the content of the aluminum compound in the low-reflection coating is, for example, 3 mass% or more and desirably 4 mass% or more.

The low-reflection coating is likely to exhibit high salt spray resistance when an aluminum halide is added to the coating liquid for forming the low-reflection coating and the low-reflection coating is formed using the coating liquid under predetermined conditions. In this case, the low-reflection coating is formed, for example, by applying the coating liquid for forming the low-reflection coating to a principal surface of the glass sheet and heating the glass sheet under such conditions that the glass sheet has a maximum temperature of 350°C or lower and that a duration during which the glass sheet has a temperature of 200°C or higher is 5 minutes or less. The low-reflection coating is desirably formed by applying the coating liquid for forming the low-reflection coating to a principal surface of the glass sheet and heating the glass sheet under such conditions that the glass sheet has a maximum temperature of 250°C or lower and that a duration during which the glass sheet has a temperature of 200°C or higher is 2 minutes or less. In this case, the low-reflection coating has high salt spray resistance. When the glass sheet is one produced by a float process, the coating liquid for forming the low-reflection coating is applied, for example, to the bottom surface of the glass sheet.

The reflectance loss of the low-reflection coated glass sheet according to the present invention, as determined after the low-reflection coated glass sheet is subjected to a wear test, is 1.8% or more, for example. That is, the low-reflection coated glass sheet according to the present invention exhibits a large reflectance loss after being subjected to a wear test. Thus, the low-reflection coated glass sheet is suitable, for example, for use as a glass sheet for a photoelectric conversion device which may be used in an environment where there are a large amount of foreign matters such as sand dust. The reflectance loss is determined by subtracting an average light reflectance of the low-reflection coated glass sheet in the wavelength range of 360 nm to 740 nm from an average light reflectance of the glass sheet unprovided with the low-reflection coating in the wavelength range of 360 nm to 740 nm, the average light reflectance of the low-reflection coated glass sheet being determined after the low-reflection coated glass sheet is subjected to a reciprocating wear test performed by moving an abrasive, CS-10F, in contact with the low-reflection coating at a load of 4 N with 50 cycles of reciprocation. The abrasive, CS-10F, is an abrasive pad manufactured by Taber Industries. In the measurement of the average reflectance of the low-reflection coated glass sheet, incident light having wavelengths of 360 nm to 740 nm is irradiated on the low-reflection coating of the low-reflection coated glass sheet. In the measurement of the average reflectance of the glass sheet unprovided with the low-reflection coating, incident light having wavelengths of 360 nm to 740 nm is irradiated on the principal surface of the glass sheet on which the low-reflection coating is to be formed.

Next, an example of the method for producing the low-reflection coated glass sheet according to the present invention will be described. The low-reflection coated glass sheet can be produced by applying a coating liquid for forming the low-reflection coating to at least a portion of a principal surface of the glass sheet and then drying and curing the applied coating liquid.

The coating liquid is prepared, for example, by adding a hydrolysis catalyst and a silicon alkoxide sequentially to a predetermined solvent under stirring. When the low-reflection coating is to contain an aluminum compound, for example, an aluminum halide such as aluminum chloride serving as a precursor of the aluminum compound is added to the coating liquid. When the low-reflection coating is to contain fine silica particles, it is desirable to carry out hydrolysis of a hydrolyzable silicon compound in a solution containing fine silica particles, because this promotes a polycondensation reaction between silanol groups present on the surfaces of the fine silica particles and silanol groups formed by hydrolysis of the hydrolyzable silicon compound, thus leading to an increase in the proportion of the silica material having the continuous structure that contributes to binding between the fine silica particles. Specifically, the coating liquid is prepared, for example, by adding a hydrolysis catalyst and a silicon alkoxide sequentially to a solution containing fine silica particles under stirring. Either an acid or a base can be used as the hydrolysis catalyst. It is desirable to use an acid, particularly an inorganic acid, more particularly hydrochloric acid, in terms of the stability of the coating liquid. It is desirable to use as the hydrolysis catalyst an acid having a high degree of electrolytic dissociation in an aqueous solution. Specifically, it is desirable to use an acid having an acid dissociation constant pKa (which refers to the first acid dissociation constant when the acid is a polybasic acid) of 2.5 or less. Examples of acids desired as the hydrolysis catalyst include: (i) volatile inorganic acids such as hydrochloric acid and nitric acid; (ii) organic acids such as trifluoroacetic acid, methanesulfonic acid, benzenesulfonic acid, and p-toluenesulfonic acid; (iii) polybasic acids such as maleic acid, phosphoric acid, and oxalic acid; (iv) sulfuric acid; and (v) sulfamic acid. An acidic hydrolysis catalyst allows better dispersion of the fine silica particles than a basic hydrolysis catalyst. Furthermore, chlorine ions derived from hydrochloric acid enhance the effect provided by incorporation of an aluminum compound in the low-reflection coating (high chemical resistance of the low-reflection coating to salt spray).

Examples of the method available for applying the coating liquid to a principal surface of the glass sheet include, but are not limited to, spin coating, roll coating, bar coating, dip coating, and spray coating. In terms of the efficiency of mass production and the uniformity of the visual appearance of the coating, it is desirable to use roll coating or bar coating to apply the coating liquid to the principal surface of the glass sheet. In terms of the efficiency of mass production, the spray coating may be used to apply the coating liquid to the principal surface of the glass sheet.

The method for drying and curing the coating liquid applied to a principal surface of the glass sheet is not particularly limited. For example, hot air drying can be used to dry and cure the applied coating liquid. In this case, the temperature conditions to be imposed on the glass sheet are not particularly limited. When the coating liquid contains an aluminum halide, it is preferable to perform hot air drying so as to meet the conditions described above.

### EXAMPLES (all not according with the invention).

Methods for test or measurement conducted on glass sheets according to Examples and Comparative Examples will first be described.

### (Reciprocating wear test)

Low-reflection coated glass sheets according to Examples and Comparative Examples were subjected to a reciprocating wear test using a reciprocating wear tester manufactured by DAIEI KAGAKU SEIKI MFG. CO., LTD. Specifically, each low-reflection coated glass sheet was fixed by a jig, with the low-reflection coating facing upward. Next, a circular abrasive of 19 mm diameter, CS-10F, was brought into contact, at its circular face, with the low-reflection coating, and a load of 4 N was applied. The area of contact between the abrasive, CS-10F, and the low-reflection coating was 284 mm². In this state, the abrasive, CS-10F, was moved straight back and forth 50 times on the low-reflection coating. The velocity of the abrasive was set to 120 mm/sec., and the stroke width of the abrasive was set to 120 mm.

### (Transmission properties)

For each of the low-reflection coated glass sheets according to Examples and Comparative Examples, the values of light reflectance in the wavelength range of 360 nm to 740 nm were measured using a spectrocolorimeter (CM-2600d manufactured by KONICA MINOLTA, INC.), and the values of light reflectance in this wavelength range were averaged to determine an average reflectance. The average reflectance determination was made before and after the reciprocating wear test for each of the low-reflection coated glass sheets according to Examples and Comparative Examples. The average reflectance determination was made in the same manner as above also for glass sheets used in the low-reflection coated glass sheets according to Examples and Comparative Examples before formation of low-reflection coatings. In each of Examples and Comparative Examples, a reflectance loss before the reciprocating wear test was determined by subtracting the average reflectance of the low-reflection coated glass sheet before the reciprocating wear test from the average reflectance of the glass sheet unprovided with the low-reflection coating. In each of Examples and Comparative Examples, a reflectance loss after the reciprocating wear test was determined by subtracting the average reflectance of the low-reflection coated glass sheet after the reciprocating wear test from the average reflectance of the glass sheet before unprovided with the low-reflection coating. In the reflectance measurement of the low-reflection coated glass sheets according to Examples and Comparative Examples, incident light having wavelengths ranging from 360 nm to 740 nm was irradiated on the low-reflection coatings. In the reflectance measurement of the glass sheets prior to formation of the low-reflection coatings, incident light having wavelengths ranging from 360 nm to 740 nm was irradiated on the bottom surface of each glass sheet. The results are shown in Table 1 and Table 2.

The transmittance spectrum of each of the low-reflection coated glass sheets according to Examples and Comparative Examples was measured using a spectrophotometer (UV-3100 manufactured by Shimadzu Corporation). The values of transmittance were averaged in the wavelength range of 380 nm to 850 nm in the transmittance spectrum to calculate an average transmittance. For the transmittance spectrum measurement, incident light was irradiated on the low-reflection coating of each of the low-reflection coated glass sheets according to Examples and Comparative Examples. In addition, for each of the glass sheets used in Examples and Comparative Examples, the measurement of transmittance spectrum and the calculation of average transmittance were performed in the absence of any low-reflection coating formed on the glass sheet. In each of Examples and Comparative Examples, a transmittance gain was calculated by subtracting the average transmittance of the glass sheet unprovided with any low-reflection coating from the average transmittance of the low-reflection coated glass sheet that had not been subjected to the reciprocating wear test. The results are shown in Table 1 and Table 2.

### (SEM observation)

The low-reflection coatings of the low-reflection coated glass sheets according to Examples and Comparative Examples were observed with a field emission scanning electron microscope (S-4500 manufactured by Hitachi, Ltd.) which is abbreviated as "FE-SEM". The thickness of each low-reflection coating was measured at five points in a FE-SEM photograph, taken from above at an angle of 30°, of a cross-section of the low-reflection coating, and the average of the measured values was calculated as the thickness of the low-reflection coating.

### <Example 1>

An amount of 39.13 parts by weight of a fine silica particle dispersion (manufactured by FUSO CHEMICAL CO., LTD. under the trade name "Quartron PL-7", containing fine silica particles having an average primary particle diameter of 125 nm, and having a solids concentration of 23 weight%), 155.05 parts by weight of 1-methoxy-2-propanol, 30.00 parts by weight of water, and 3.00 parts by weight of IN hydrochloric acid were mixed by stirring, and then 72.82 parts by weight of tetraethoxysilane (ethyl orthosilicate manufactured by TAMA CHEMICALS CO., LTD.) was added to the mixture, which was further stirred for 8 hours while maintaining a temperature of 40°C to hydrolyze the tetraethoxysilane, thus giving a raw material liquid A. In the raw material liquid A, the concentration of solids calculated as SiO₂ was 10 weight%. The ratio (Mw/Ma) of the number of moles (Mw) of water to the number of moles (Ma) of the alkoxy group in the raw material liquid A was 8.7. An amount of 140.00 g of the raw material liquid A, 4.00 g of propylene glycol, and 56.00 g of 1-methoxy-2-propanol were mixed by stirring to obtain a coating liquid A1. In the coating liquid A1, the concentration of solids of silicon oxide (derived from tetraethoxysilane) calculated as SiO₂ was 7.00 weight%.

A glass sheet produced by a float process and having dimensions of 200 mm × 150 mm × 3.2 mm was prepared. This glass sheet had a typical soda-lime silicate composition. This glass sheet showed an average light reflectance of 8.2% in the wavelength range of 360 nm to 740 nm and an average light transmittance of 90.1% in the wavelength range of 380 nm to 850 nm in the absence of any low-reflection coating formed on the glass sheet. The coating liquid A1 was applied to the bottom surface of the glass sheet using a roll coater so that the applied liquid formed a layer of 1 µm to 5 µm thickness. Next, the coating liquid A1 applied to the bottom surface of the glass sheet was dried and cured using a belt-conveyor type hot air dryer. Specifically, the glass sheet was moved back and forth twice in the hot air dryer and thus passed under a hot air injection nozzle four times, with the temperature of hot air set to 300°C, the distance between the hot air injection nozzle and the glass sheet set to 5 mm, and the conveyance speed set to 0.5 m/min. In this process, the duration during which the glass sheet coated with the coating liquid was in contact with hot air was 140 seconds, and the maximum temperature reached by the glass sheet surface (bottom surface) coated with the coating liquid was 195°C. The glass sheet was subsequently left to cool to room temperature, and thus a low-reflection coated glass sheet according to Example 1 was obtained.

### <Example 2>

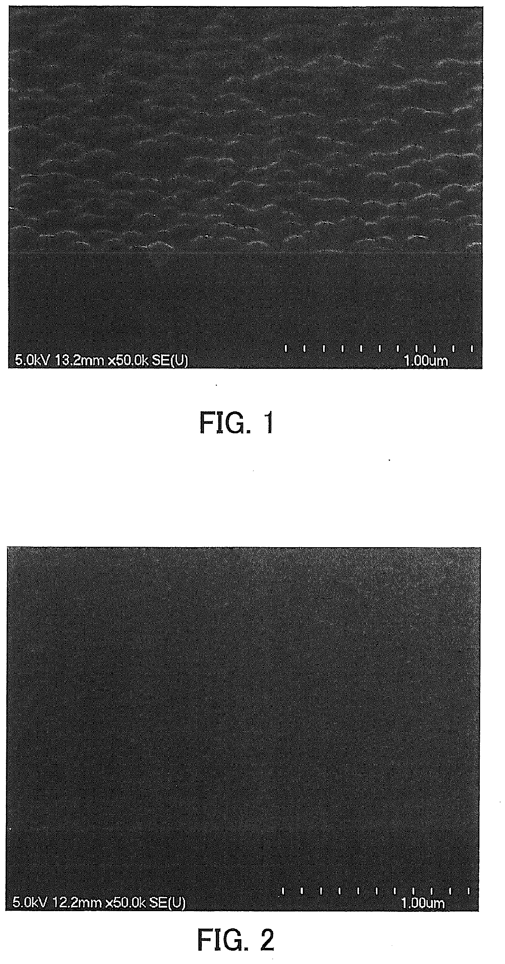

A low-reflection coated glass sheet according to Example 2 was obtained in the same manner as in Example 1, except for preparing a coating liquid by using an aqueous aluminum chloride solution in addition to the raw materials of Example 1 so that the contents of the components in the resulting low-reflection coating were adjusted to those shown in Table 1. A FE-SEM photograph of the low-reflection coated glass sheet according to Example 2 is shown in FIG. 1.

### <Example 3>

A low-reflection coated glass sheet according to Example 3 was obtained in the same manner as in Example 1, except for preparing a coating liquid by using the raw materials of Example 1 so that the contents of the components in the resulting low-reflection coating were adjusted to those shown in Table 1.

### <Examples 4 and 5>

Low-reflection coated glass sheets according to Examples 4 and 5 were obtained in the same manner as in Example 2, except for preparing coating liquids by using the raw materials of Example 2 so that the contents of the components in the resulting low-reflection coatings were adjusted to those shown in Table 1.

### <Example 6>

A low-reflection coated glass sheet according to Example 6 was obtained in the same manner as in Example 1, except for preparing a coating liquid by employing a fine silica particle dispersion (manufactured by FUSO CHEMICAL CO., LTD. under the trade name "Quartron PL-1" and containing fine silica particles having an average primary particle diameter of 15 nm) different than that used in Example 1 and by using the different fine silica particle dispersion and the raw materials of Example 1 other than the fine silica particle dispersion so that the contents of the components in the resulting low-reflection coating were adjusted to those shown in Table 1.

### <Example 7>

A low-reflection coated glass sheet according to Example 7 was obtained in the same manner as in Example 1, except for preparing a coating liquid by substituting a partial hydrolysis-condensation product of tetraethoxysilane (a compound composed of five monomer units on average, manufactured by COLCOAT CO., LTD. under the trade name "Ethyl Silicate 40" which is abbreviated as "ES-40") for tetraethoxysilane and by using the partial hydrolysis-condensation product and the raw materials of Example 1 other than the fine silica particle dispersion and tetraethoxysilane so that the resulting low-reflection coating contained no fine silica particles as shown in Table 1.

### <Example 8>

A low-reflection coated glass sheet according to Example 8 was obtained in the same manner as in Example 1, except for preparing a coating liquid by using the raw materials of Example 1 so that the contents of the components in the resulting low-reflection coating were adjusted to those shown in Table 1.

### <Example 9>

A low-reflection coated glass sheet according to Example 9 was obtained in the same manner as in Example 1, except for preparing a coating liquid containing no fine silica particles by using methyltriethoxysilane and the raw materials of Example 1 other than the fine silica particle dispersion so that the contents of the components in the resulting low-reflection coating were adjusted to those shown in Table 1. In the coating liquid, the molar ratio between tetraethoxysilane and methyltriethoxysilane was 9 : 1.

### <Example 10>

A low-reflection coated glass sheet according to Example 10 was obtained in the same manner as in Example 6, except for preparing a coating liquid by using the raw materials of Example 6 so that the contents of the components in the resulting low-reflection coating were adjusted to those shown in Table 1. A FE-SEM photograph of the low-reflection coated glass sheet according to Example 10 is shown in FIG. 2.

### <Example 11>

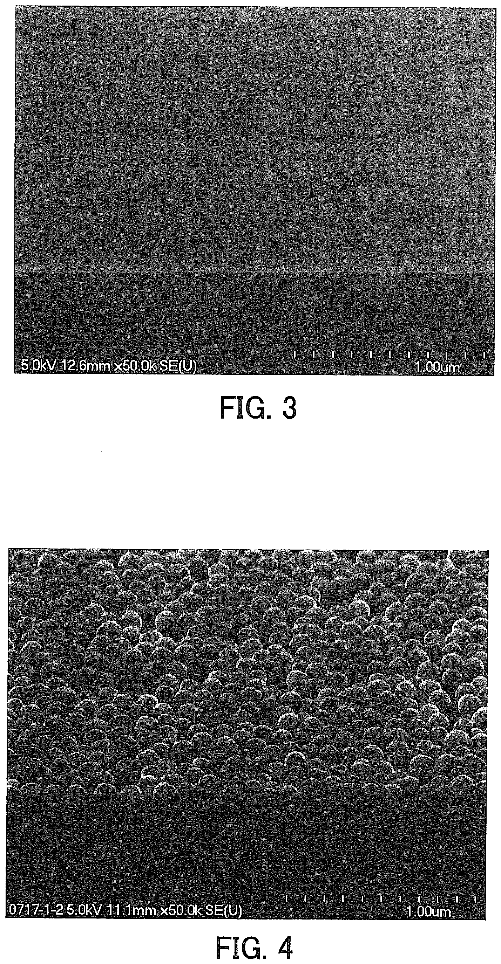

A low-reflection coated glass sheet according to Example 11 was obtained in the same manner as in Example 1, except for preparing a coating liquid containing no fine silica particles by using the raw materials of Example 1 other than the fine silica particle dispersion so that the contents of the components in the resulting low-reflection coating were adjusted to those shown in Table 1. A FE-SEM photograph of the low-reflection coated glass sheet according to Example 11 is shown in FIG. 3.

### <Example 12>

A low-reflection coated glass sheet according to Example 12 was obtained in the same manner as in Example 6, except for preparing a coating liquid by substituting the partial hydrolysis-condensation product of tetraethoxysilane used in Example 7 for tetraethoxysilane and by using the partial hydrolysis-condensation product and the raw materials of Example 6 other than the tetraethoxysilane so that the contents of the components in the resulting low-reflection coating were adjusted to those shown in Table 1.

### <Example 13>

A low-reflection coated glass sheet according to Example 13 was obtained in the same manner as in Example 8, except for preparing a coating liquid by using the raw materials of Example 1 and methyltriethoxysilane (MTES) so that the contents of the components were adjusted to those shown in Table 2. The low-reflection coating of the low-reflection coated glass sheet according to Example 13 contained an organic group, since methyl which was contained as a non-hydrolyzable organic group in MTES remained in the coating. When the low-reflection coating of the low-reflection coated glass sheet according to Example 13 was considered to consist of a silica material having a continuous structure and fine silica particles, the content of the silica material having the continuous structure in the low-reflection coating was 75 mass%, while the content of the fine silica particles was 25 mass%. The content of a hydrolysis-condensation product of MTES was 38 parts by mass with respect to 100 parts by mass of the silica material having the continuous structure. When the low-reflection coating of the low-reflection coated glass sheet according to Example 13 was considered to consist of an organic group and inorganic component, the content of the organic group was 6.4 mass%.

### <Examples 14 and 15>

Low-reflection coated glass sheets according to Examples 14 and 15 were obtained in the same manner as in Example 13, except for preparing coating liquids so that the contents of the components were adjusted to those shown in Table 2. For the low-reflection coatings of the low-reflection coated glass sheets according to Examples 14 and 15, the content of a hydrolysis-condensation product of MTES was 20 parts by mass in Example 14 and 5 parts by mass in Example 15 with respect to 100 parts by mass of the silica material having the continuous structure. The composition and properties of the low-reflection coating of the low-reflection coated glass sheet according to Example 8 are also listed in Table 2 for reference.

### <Comparative Example 1>

A low-reflection coated glass sheet according to Comparative Example 1 was obtained in the same manner as in Example 2, except for preparing a coating liquid by using the raw materials of Example 2 so that the contents of the components in the resulting low-reflection coating were adjusted to those shown in Table 1.

### <Comparative Example 2>

A low-reflection coated glass sheet according to Comparative Example 2 was obtained in the same manner as in Example 1, except for preparing a coating liquid by using the raw materials of Example 1 so that the contents of the components in the resulting low-reflection coating were adjusted to those shown in Table 1. A FE-SEM photograph of the low-reflection coated glass sheet according to Comparative Example 2 is shown in FIG. 4.

### <Comparative Example 3>

A low-reflection coated glass sheet according to Comparative Example 3 was obtained in the same manner as in Example 6, except for preparing a coating liquid by using the raw materials of Example 6 so that the contents of the components in the resulting low-reflection coating were adjusted to those shown in Table 1.

For the low-reflection coated glass sheets according to Comparative Examples 1 and 2, the transmittance gain was 2.60% or more, and the reflectance loss as determined before the wear test was 3.35% or more; however, the reflectance loss as determined after the wear test was less than 1.7%. This suggests that the low-reflection coatings of the low-reflection coated glass sheets according to Comparative Examples 1 and 2 can experience deterioration in low-reflection properties when scraping against foreign matters. By contrast, for the low-reflection coated glass sheets according to Examples 1 to 12, the reflectance loss as determined after the wear test was 1.9% or more, although the transmittance gain was 1.4 to 2.1% or so and the reflectance loss as determined before the wear test was 2.0 to 3.3% or so. This suggests that the low-reflection coatings of the low-reflection coated glass sheets according to Examples 1 to 12 are resistant to deterioration in low-reflection properties caused by scraping against foreign matters and have a high potential to maintain the initial low-reflection properties.

In particular, for the low-reflection coated glass sheets according to Examples 1 to 5 in which the content of the silica material having the continuous structure in the low-reflection coating was 60 mass% to 75 mass%, the reflectance loss as determined after the wear test was more than 2.2%. This suggests that the low-reflection coated glass sheets according to Examples 1 to 5 would be capable of maintaining good low-reflection properties over a long period of time. In the low-reflection coated glass sheets according to Examples 1 to 5, the average thickness of the low-reflection coating was in the range of 100 nm to 200 nm, and the diameter of the fine silica particles was in the range of 50 nm to 150 nm. This leads to the inference that, in the low-reflection coated glass sheets according to Examples 1 to 5, a portion of each fine silica particle was exposed outside of the silica material having the continuous structure to form asperities on the surface of the low-reflection coating as shown, for example, in FIG. 1, and the surface asperities provided good low-reflection properties. It can also be inferred that the unexposed portions of the fine silica particles were chemically liked with, and embedded in, the silica material having the continuous structure so that the low-reflection coated glass sheets according to Examples 1 to 5 would be capable of resisting deterioration in low-reflection properties when scraping against foreign matters.

In the low-reflection coated glass sheets according to Examples 7 and 9 to 12, the low-reflection coating contained no fine silica particles, or the fine silica particles had an average particle diameter of 20 nm or less. The content of the silica material having the continuous structure in the low-reflection coating was 85 mass% or more. This is presumably why, for the low-reflection coated glass sheets according to Examples 7 and 9 to 12, the increase in average reflectance caused by the wear test was less than 0.4% as shown in Table 1, although the reflectance loss as determined after the wear test was 1.9 to 2.1%. This result suggests that the low-reflection coatings of the low-reflection coated glass sheets according to Examples 7 and 9 to 12 would be capable of maintaining good low-reflection properties over a long period of time.

The silica material having the continuous structure in each of the low-reflection coated glass sheets according to Examples 13 to 15 contained an organic group (methyl group). The low-reflection coated glass sheets according to Examples 13 to 15 showed a higher transmittance gain, and a higher reflectance loss as determined after the wear test, than the low-reflection coated glass sheet according to Example 8. This suggests that when the silica material having the continuous structure in the low-reflection coated glass sheet contains an organic group, the low-reflection coated glass sheet is likely to show a high transmittance gain and to maintain good low-reflection properties when scraping against foreign matters.

In the low-reflection coated glass sheets according to Examples 2, 4, and 5, the low-reflection coating contained a predetermined amount of aluminum compound. This leads to the inference that the low-reflection coated glass sheets according to Examples 2, 4, and 5 would be superior in terms of chemical resistance such as salt spray resistance of the low-reflection coating, despite the fact that the maximum temperature reached by the glass sheet during the heating step subsequent to application of the coating liquid to the glass sheet was low (195°C).

**[Table 1]**

| | Contents of components in low-reflection coating [mass%] | | | Silica components in coating liquid | | | Amount of AlCl₃ added per 100 parts by mass of silica components [parts by mass] | Average thickness of low-reflection coating [nm] | Transmittance gain [%] | Reflectance loss [%] | | Increase in average reflectance caused by wear test [%] |
|---|---|---|---|---|---|---|---|---|---|---|---|---|
| | Silica material having continuous structure | Fine silica particles | AlCl₃ (Calculated as Al₂O₃) | Silica material having continuous structure [parts by mass] | Fine silica particles [parts by mass] | Average particle diameter of fine silica particles [nm] | | | | Before wear test | After wear test | |
| Example 1 | 70.0 | 30.0 | - | 70 | 30 | 125 | - | 160 | 1.97 | 3.33 | 2.79 | 0.54 |
| Example 2 | 71.4 | 23.8 | 4.8 | 75 | 25 | 125 | 5 | 160 | 1.91 | 3.12 | 2.52 | 0.60 |
| Example 3 | 65.0 | 35.0 | - | 65 | 35 | 125 | - | 160 | 2.08 | 3.29 | 2.38 | 0.91 |
| Example 4 | 66.7 | 28.5 | 4.8 | 70 | 30 | 125 | 5 | 160 | 1.95 | 3.12 | 2.33 | 0.79 |
| Example 5 | 61.9 | 33.3 | 4.8 | 65 | 35 | 125 | 5 | 160 | 2.08 | 3.28 | 2.27 | 1.01 |
| Example 6 | 75.0 | 25.0 | - | 75 | 25 | 15 | - | 160 | 1.79 | 2.83 | 2.04 | 0.79 |
| Example 7 | 100.0 | 0.0 | - | 100 | 0 | - | | 120 | 1.68 | 2.35 | 2.02 | 0.33 |
| Example 8 | 75.0 | 25.0 | - | 75 | 25 | 125 | - | 160 | 1.98 | 2.72 | 2.01 | 0.71 |
| Example 9 | 100.0 | 0.0 | - | 100 | 0 | - | | 120 | 1.70 | 2.35 | 1.98 | 0.37 |
| Example 10 | 90.0 | 10.0 | - | 90 | 10 | 15 | - | 120 | 1.56 | 2.03 | 1.96 | 0.07 |
| Example 11 | 100.0 | 0.0 | - | 100 | 0 | - | - | 120 | 1.68 | 2.22 | 1.95 | 0.27 |
| Example 12 | 90.0 | 10.0 | - | 90 | 10 | 15 | - | 120 | 1.46 | 2.58 | 2.19 | 0.39 |
| Comparative Example 1 | 33.3 | 61.9 | 4.8 | 35 | 65 | 125 | 5 | 140 | 2.72 | 3.51 | 1.55 | 1.96 |
| Comparative Example 2 | 50.0 | 50.0 | | 50 | 50 | 125 | - | 140 | 2.60 | 3.35 | 1.35 | 2.00 |
| Comparative Example 3 | 50.0 | 50.0 | - | 50 | 50 | 15 | - | 120 | 1.41 | 1.94 | 1.67 | 0.27 |

**[Table 2]**

| | Contents of components in low-reflection coating [mass%] | | | | | Average particle diameter of fine silica particles [nm] | Average thickness of low-reflection coating [nm] | Transmittance gain [%] | Reflectance loss [%] | | Increase in average reflectance caused by wear test [%] |
|---|---|---|---|---|---|---|---|---|---|---|---|
| | Silica material having continuous structure | | | Fine silica particles | Organic group (Methyl) | | | | Before wear test | After wear test | |
| | Hydrolysis-condensation product of tetraethoxysilane siO₂ | Hydrolysis-condensation product of MTES RSiO₁₅ | Total | | | | | | | | |
| Example 13 | 46.5 | 28.5 | 75.0 | 25.0 | 6.4 | 125 | 160 | 2.16 | 3.02 | 2.14 | 0.88 |
| Example 14 | 60.0 | 15.0 | 75.0 | 25.0 | 3.4 | 125 | 160 | 2.11 | 3.38 | 2.50 | 0.89 |
| Example 15 | 71.3 | 3.8 | 75.0 | 25.0 | 0.8 | 125 | 160 | 2.05 | 3.09 | 2.48 | 0.61 |
| Example 8 | 75.0 | 0.0 | 75.0 | 25.0 | 0.0 | 125 | 160 | 1.98 | 2.72 | 2.01 | 0.71 |

## Claims

1. A low-reflection coated glass sheet comprising:
a glass sheet; and
a low-reflection coating containing 60 mass% to 100 mass% of a silica material having a continuous structure, the low-reflection coating being formed on at least a portion of a principal surface of the glass sheet,
wherein the low-reflection coating further contains an aluminum compound, and
the content of the aluminum compound, calculated as Al₂O₃, in the low-reflection coating is 2 mass% to 8 mass%,
wherein the silica material having the continuous structure contains an organic group, and
the content of the organic group in the low-reflection coating is 0.3 to 7 mass%.

2. The low-reflection coated glass sheet according to claim 1, wherein the content of the silica material having the continuous structure in the low-reflection coating is 60 mass% to 95 mass%.

3. The low-reflection coated glass sheet according to claim 1, wherein the content of the silica material having the continuous structure in the low-reflection coating is 80 mass% to 100 mass%.

4. The low-reflection coated glass sheet according to claim 2, wherein the content of the silica material having the continuous structure in the low-reflection coating is 60 mass% to 80 mass%.

5. The low-reflection coated glass sheet according to claim 2, wherein
the low-reflection coating further contains fine silica particles having an average particle diameter of 5 nm to 300 nm,
the content of the silica material having the continuous structure in the low-reflection coating is 60 mass% to 95 mass%, and
the content of the fine silica particles in the low-reflection coating is 5 mass% to 40 mass%.

6. The low-reflection coated glass sheet according to claim 5, wherein
the fine silica particles have an average particle diameter of 5 nm to 30 nm,
the content of the silica material having the continuous structure in the low-reflection coating is 70 mass% to 95 mass%, and
the content of the fine silica particles in the low-reflection coating is 5 mass% to 30 mass%.

7. The low-reflection coated glass sheet according to claim 5, wherein
the fine silica particles have an average particle diameter of 30 nm to 150 nm,
the content of the silica material having the continuous structure in the low-reflection coating is 60 mass% to 80 mass%, and
the content of the fine silica particles in the low-reflection coating is 20 mass% to 40 mass%.

8. The low-reflection coated glass sheet according to claim 1, wherein
the glass sheet is produced by a float process, and
the low-reflection coating is formed on at least a portion of a bottom surface of the glass sheet,
wherein the bottom surface is a surface formed by glass having contacted with molten tin in a float bath in the float process.

9. The low-reflection coated glass sheet according to claim 1, wherein the low-reflection coating is formed by applying a coating liquid for forming the low-reflection coating to the principal surface of the glass sheet and heating the glass sheet under such conditions that the glass sheet has a maximum temperature of 350°C or lower and that a duration during which the glass sheet has a temperature of 200°C or higher is 5 minutes or less.

10. The low-reflection coated glass sheet according to claim 1, wherein the low-reflection coating is formed by applying a coating liquid for forming the low-reflection coating to the principal surface of the glass sheet and heating the glass sheet under such conditions that the glass sheet has a maximum temperature of 250°C or lower and that a duration during which the glass sheet has a temperature of 200°C or higher is 2 minutes or less.

11. The low-reflection coated glass sheet according to claim 1, wherein a reflectance loss is 1.8% or more, the reflectance loss being determined by subtracting an average light reflectance of the low-reflection coated glass sheet in the wavelength range of 360 nm to 740 nm from an average light reflectance of the glass sheet unprovided with the low-reflection coating in the wavelength range of 360 nm to 740 nm, the average light reflectance of the low-reflection coated glass sheet being determined after the low-reflection coated glass sheet is subjected to a reciprocating wear test performed by moving an abrasive, CS-10F, in contact with the low-reflection coating at a load of 4 N with 50 cycles of reciprocation.

## Patentansprüche

1. Beschichtete Glasplatte mit geringer Reflexion, umfassend:
eine Glasplatte, und
eine Beschichtung mit geringer Reflexion, die 60 Massenprozent bis 100 Massenprozent eines Siliziumoxidmaterials enthält, das eine ununterbrochene Struktur aufweist, wobei die Beschichtung mit geringer Reflexion auf mindestens einem Abschnitt einer Hauptoberfläche der Glasplatte gebildet ist,
wobei die Beschichtung mit geringer Reflexion ferner eine Aluminiumverbindung enthält und
der Gehalt an der Aluminiumverbindung, berechnet als Al₂O₃, in der Beschichtung mit geringer Reflexion 2 Massenprozent bis 8 Massenprozent beträgt,
wobei das Siliziumoxidmaterial, das die ununterbrochene Struktur aufweist, eine organische Gruppe enthält und
der Gehalt an der organischen Gruppe in der Beschichtung mit geringer Reflexion 0,3 bis 7 Massenprozent beträgt.

2. Beschichtete Glasplatte mit geringer Reflexion nach Anspruch 1, wobei der Gehalt an dem Siliziumoxidmaterial, das die ununterbrochene Struktur aufweist, in der Beschichtung mit geringer Reflexion 60 Massenprozent bis 95 Massenprozent beträgt.

3. Beschichtete Glasplatte mit geringer Reflexion nach Anspruch 1, wobei der Gehalt an dem Siliziumoxidmaterial, das die ununterbrochene Struktur aufweist, in der Beschichtung mit geringer Reflexion 80 Massenprozent bis 100 Massenprozent beträgt.

4. Beschichtete Glasplatte mit geringer Reflexion nach Anspruch 2, wobei der Gehalt an dem Siliziumoxidmaterial, das die ununterbrochene Struktur aufweist, in der Beschichtung mit geringer Reflexion 60 Massenprozent bis 80 Massenprozent beträgt.

5. Beschichtete Glasplatte mit geringer Reflexion nach Anspruch 2, wobei
die Beschichtung mit geringer Reflexion ferner feine Siliziumoxidpartikel enthält, die einen durchschnittlichen Partikeldurchmesser von 5 nm bis 300 nm aufweisen,
der Gehalt an dem Siliziumoxidmaterial, das die ununterbrochene Struktur aufweist, in der Beschichtung mit geringer Reflexion 60 Massenprozent bis 95 Massenprozent beträgt und
der Gehalt an den feinen Siliziumoxidpartikeln in der Beschichtung mit geringer Reflexion 5 Massenprozent bis 40 Massenprozent beträgt.

6. Beschichtete Glasplatte mit geringer Reflexion nach Anspruch 5, wobei
die feinen Siliziumoxidpartikel einen durchschnittlichen Partikeldurchmesser von 5 nm bis 30 nm aufweisen,
der Gehalt an dem Siliziumoxidmaterial, das die ununterbrochene Struktur aufweist, in der Beschichtung mit geringer Reflexion 70 Massenprozent bis 95 Massenprozent beträgt und
der Gehalt an den feinen Siliziumoxidpartikeln in der Beschichtung mit geringer Reflexion 5 Massenprozent bis 30 Massenprozent beträgt.

7. Beschichtete Glasplatte mit geringer Reflexion nach Anspruch 5, wobei
die feinen Siliziumoxidpartikel einen durchschnittlichen Partikeldurchmesser von 30 nm bis 150 nm aufweisen,
der Gehalt an dem Siliziumoxidmaterial, das die ununterbrochene Struktur aufweist, in der Beschichtung mit geringer Reflexion 60 Massenprozent bis 80 Massenprozent beträgt und
der Gehalt an den feinen Siliziumoxidpartikeln in der Beschichtung mit geringer Reflexion 20 Massenprozent bis 40 Massenprozent beträgt.

8. Beschichtete Glasplatte mit geringer Reflexion nach Anspruch 1, wobei
die Glasplatte durch einen Float-Prozess hergestellt wird und
die Beschichtung mit geringer Reflexion auf mindestens einem Abschnitt einer unteren Oberfläche der Glasplatte gebildet ist,
wobei die untere Oberfläche eine Oberfläche ist, die durch Glas gebildet ist, das in dem Float-Prozess mit geschmolzenem Zinn in einem Float-Bad in Kontakt gebracht wurde.

9. Beschichtete Glasplatte mit geringer Reflexion nach Anspruch 1, wobei die Beschichtung mit geringer Reflexion durch Aufbringen einer Beschichtungsflüssigkeit zum Bilden der Beschichtung mit geringer Reflexion auf die Hauptoberfläche der Glasplatte und Erhitzen der Glasplatte unter Bedingungen gebildet wird, die derart sind, dass die Glasplatte eine Höchsttemperatur von 350 °C oder niedriger aufweist und dass eine Dauer, während der die Glasplatte eine Temperatur von 200 °C oder höher aufweist, 5 Minuten oder weniger beträgt.

10. Beschichtete Glasplatte mit geringer Reflexion nach Anspruch 1, wobei die Beschichtung mit geringer Reflexion durch Aufbringen einer Beschichtungsflüssigkeit zum Bilden der Beschichtung mit geringer Reflexion auf die Hauptoberfläche der Glasplatte und Erhitzen der Glasplatte unter Bedingungen gebildet wird, die derart sind, dass die Glasplatte eine Höchsttemperatur von 250 °C oder niedriger aufweist und dass eine Dauer, während der die Glasplatte eine Temperatur von 200 °C oder höher aufweist, 2 Minuten oder weniger beträgt.

11. Beschichtete Glasplatte mit geringer Reflexion nach Anspruch 1, wobei ein Verlust des Reflexionsvermögens 1,8 % oder mehr beträgt und der Verlust des Reflexionsvermögens durch Subtrahieren eines durchschnittlichen Lichtreflexionsvermögens der beschichteten Glasplatte mit geringer Reflexion in dem Wellenlängenbereich von 360 nm bis 740 nm von einem durchschnittlichen Lichtreflexionsvermögen der nicht mit der Beschichtung mit geringer Reflexion versehenen Glasplatte in dem Wellenlängenbereich von 360 nm bis 740 nm bestimmt wird, wobei das durchschnittliche Lichtreflexionsvermögen der beschichteten Glasplatte mit geringer Reflexion bestimmt wird, nachdem die beschichtete Glasplatte mit geringer Reflexion einer Schwingungs-Verschleißprüfung unterzogen wurde, die durch Bewegen eines Schleifmittels, CS-10F, im Kontakt mit der Beschichtung mit geringer Reflexion bei einer Last von 4 N mit 50 Schwingungszyklen durchgeführt wird.

## Revendications

1. Feuille de verre revêtue de faible réflexion comprenant :
une feuille de verre ; et
un revêtement de faible réflexion contenant 60 % en masse à 100 % en masse d'un matériau de silice ayant une structure continue, le revêtement de faible réflexion étant formé sur au moins une portion d'une surface principale de la feuille de verre,
dans laquelle le revêtement de faible réflexion contient de plus un composé d'aluminium, et
la teneur du composé d'aluminium, calculée comme Al₂O₃, dans le revêtement de faible réflexion est de 2 % en masse à 8 % en masse,
dans laquelle le matériau de silice ayant la structure continue contient un groupe organique, et
la teneur du groupe organique dans le revêtement de faible réflexion est de 0,3 à 7 % en masse.

2. Feuille de verre revêtue de faible réflexion selon la revendication 1, dans laquelle la teneur du matériau de silice ayant la structure continue dans le revêtement de faible réflexion est de 60 % en masse à 95 % en masse.

3. Feuille de verre revêtue de faible réflexion selon la revendication 1, dans laquelle la teneur du matériau de silice ayant la structure continue dans le revêtement de faible réflexion est de 80 % en masse à 100 % en masse.

4. Feuille de verre revêtue de faible réflexion selon la revendication 2, dans laquelle la teneur du matériau de silice ayant la structure continue dans le revêtement de faible réflexion est de 60 % en masse à 80 % en masse.

5. Feuille de verre revêtue de faible réflexion selon la revendication 2, dans laquelle
le revêtement de faible réflexion contient de plus de fines particules de silice ayant un diamètre moyen de particule de 5 nm à 300 nm,
la teneur du matériau de silice ayant la structure continue dans le revêtement de faible réflexion est de 60 % en masse à 95 % en masse, et
la teneur des fines particules de silice dans le revêtement de faible réflexion est de 5 % en masse à 40 % en masse.

6. Feuille de verre revêtue de faible réflexion selon la revendication 5, dans laquelle
les fines particules de silice présentent un diamètre moyen de particule de 5 nm à 30 nm,
la teneur du matériau de silice ayant la structure continue dans le revêtement de faible réflexion est de 70 % en masse à 95 % en masse, et
la teneur des fines particules de silice dans le revêtement de faible réflexion est de 5 % en masse à 30 % en masse.

7. Feuille de verre revêtue de faible réflexion selon la revendication 5, dans laquelle
les fines particules de silice ont un diamètre moyen de particule de 30 nm à 150 nm,
la teneur du matériau de silice ayant la structure continue dans le revêtement de faible réflexion est de 60 % en masse à 80 % en masse, et
la teneur des fines particules de silice dans le revêtement de faible réflexion est de 20 % en masse à 40 % en masse.

8. Feuille de verre revêtue de faible réflexion selon la revendication 1, dans laquelle
la feuille de verre est produite par un procédé de flottage, et
le revêtement de faible réflexion est formé sur au moins une portion d'une surface de fond de la feuille de verre,
dans laquelle la surface de fond est une surface formée par du verre ayant été mis en contact avec de l'étain fondu dans un bain de flottage dans le procédé de flottage.

9. Feuille de verre revêtue de faible réflexion selon la revendication 1, dans laquelle le revêtement de faible réflexion est formé par application d'un liquide de revêtement pour former le revêtement de faible réflexion à la surface principale de la feuille de verre et chauffage de la feuille de verre dans des conditions telles que la feuille de verre présente une température maximale de 350°C ou inférieure et qu'une durée pendant laquelle la feuille de verre présente une température de 200°C ou supérieure est de 5 minutes ou inférieure.

10. Feuille de verre revêtue de faible réflexion selon la revendication 1, dans laquelle le revêtement de faible réflexion est formé par application d'un liquide de revêtement pour former le revêtement de faible réflexion à la surface principale de la feuille de verre et chauffage de la feuille de verre dans des conditions telles que la feuille de verre présente une température maximale de 250°C ou inférieure et qu'une durée pendant laquelle la feuille de verre présente une température de 200°C ou supérieure est de 2 minutes ou inférieure.

11. Feuille de verre revêtue de faible réflexion selon la revendication 1, dans laquelle une perte de réflectance est de 1,8 % ou supérieure, la perte de réflectance étant déterminée en soustrayant une réflectance moyenne de lumière de la feuille de verre revêtue de faible réflexion dans l'intervalle de longueur d'onde de 360 nm à 740 nm d'une réflectance moyenne de lumière de la feuille de verre non munie du revêtement de faible réflexion dans l'intervalle de longueur d'onde de 360 nm à 740 nm, la réflectance moyenne de lumière de la feuille de verre revêtue de faible réflexion étant déterminée après que la feuille de verre revêtue de faible réflexion est soumise à un test d'usure de va-et-vient réalisé en déplaçant un abrasif, CS-10F, en contact avec le revêtement de faible réflexion à une charge de 4 N avec 50 cycles de va-et-vient.
